# EUROPÄISCHE PATENTSCHRIFT

(11) **EP 2 865 024 B1**
(45) Veröffentlichungstag und Bekanntmachung des Hinweises auf die Patenterteilung: **25.04.2018**
(21) Anmeldenummer: 13731756.6
(22) Anmeldetag: 25.06.2013
(51) Int. Cl.: H01L 35/34

(54) **FADEN MIT EINEM THERMOELEKTRISCHEN WERKSTOFF UND VERFAHREN ZUR HERSTELLUNG EINES BAUELEMENTS FÜR EIN THERMOELEKTRISCHES MODUL**
THREAD COMPRISING A THERMOELECTRIC MATERIAL AND METHOD FOR PRODUCING A COMPONENT FOR A THERMOELECTRIC MODULE
FIL COMPORTANT UN MATÉRIAU THERMOÉLECTRIQUE ET PROCÉDÉ DE FABRICATION D'UN COMPOSANT DESTINÉ À UN MODULE THERMOÉLECTRIQUE

(30) Priorität: 25.06.2012 DE 102012105496
(43) Veröffentlichungstag der Anmeldung: 29.04.2015
(73) Patentinhaber: Continental Automotive GmbH, 30165 Hannover (DE)
(72) Erfinder: BRÜCK, Rolf, 51429 Bergisch Gladbach (DE); MÜLLER, Wilfried, 51789 Lindlar (DE)
(86) Internationale Anmeldenummer: PCT/EP2013/063289
(87) Internationale Veröffentlichungsnummer: WO 2014/001339

(56) Entgegenhaltungen:
- US-A1- 2007 164 270
- US-A1- 2009 004 086
- US-A1- 2011 226 302

## Beschreibung

Die vorliegende Erfindung betrifft ein Verfahren zur Herstellung eines Bauelements für ein thermoelektrisches Modul.

Ein thermoelektrisches Modul ist zur Erzeugung elektrischer Energie geeignet, z. B. aus dem Abgas einer Verbrennungskraftmaschine mittels eines Generators. Damit ist insbesondere ein Generator zur Umwandlung thermischer Energie eines Abgases in elektrische Energie gemeint, also ein sogenannter thermoelektrischer Generator.

Das Abgas aus einer Verbrennungskraftmaschine eines Kraftfahrzeugs besitzt thermische Energie, welche mittels eines thermoelektrischen Generators in elektrische Energie umgewandelt werden kann, um beispielsweise eine Batterie oder einen anderen Energiespeicher zu füllen und/oder elektrischen Verbrauchern die benötigte Energie direkt zuzuführen. Damit wird das Kraftfahrzeug mit einem besseren energetischen Wirkungsgrad betrieben und es steht für den Betrieb des Kraftfahrzeugs Energie in größerem Umfang zur Verfügung.

Ein thermoelektrisches Modul weist zumindest eine Mehrzahl thermoelektrischer Elemente auf. Thermoelektrische Materialien/Werkstoffe sind von einer Art, dass diese effektiv thermische Energie in elektrische Energie umwandeln können (Seebeck-Effekt) und umgekehrt (Peltier-Effekt). Thermoelektrische Elemente umfassen z. B. wenigstens zwei Halbleiterelemente (p-dotiert und n-dotiert), die an ihren einander gegenüberliegenden Enden, die zu einer Heißseite beziehungsweise zu einer Kaltseite hin orientiert und wechselseitig mit Brücken aus elektrisch leitendem Werkstoff versehen sind. In einem thermoelektrischen Modul sind zahlreiche dieser Halbleiterelemente elektrisch in Reihe geschaltet. Damit sich die generierte Potentialdifferenz der seriellen Halbleiterelemente nicht gegenseitig aufhebt, sind stets wechselweise Halbleiterelemente mit unterschiedlichen Majoritätsladungsträgern (n-dotiert und p-dotiert) in direkten elektrischen Kontakt gebracht. Mittels eines angeschlossenen Lastwiderstands kann der Stromkreis geschlossen und somit eine elektrische Leistung abgegriffen werden.

Es ist bereits versucht worden, entsprechende thermoelektrische Module für die Anwendung in Kraftfahrzeugen, insbesondere in Personenkraftfahrzeugen, bereitzustellen. Diese waren jedoch meist teuer in der Herstellung und gekennzeichnet durch einen relativ geringen Wirkungsgrad. Damit konnte noch keine Serientauglichkeit erlangt werden.

Insbesondere sind die Verfahren zur Herstellung eines thermoelektrischen Moduls aufwendig und kostenintensiv, weil eine Vielzahl von Bauteilen zu einem thermoelektrischen Modul zusammengesetzt und entsprechend Bauteiltoleranzen aufeinander abgestimmt werden müssen.

Die US 2009/004086 A1 betrifft ein Verfahren zur Herstellung von fadenförmigem thermoelektrischen Nanomaterial. Im Rahmen des Verfahrens wird eine Schmelze oder Lösung bestehend aus einem Trägermaterial und einem thermoelektrischen Material bereitgestellt und ein Faden aus dieser Schmelze oder Lösung gesponnen. Der Faden wird mit einer elektrischen Isolierung beschichtet. Als Trägermaterial werden Polymere (Copolymere, Homopolymere) eingesetzt.

Die US 2007/0164270 A1 betrifft die Herstellung von Nanofäden aus thermoelektrischem Material. Die Nanofäden sind in einer Polymermatrix parallel zueinander ausgerichtet und bilden so ein thermoelektrisches Element.

Die US 2011/0226302 A1 betrifft ein rohrförmiges thermoelektrisches Modul mit ringförmigen, n- und p-dotierten thermoelektrischen Materialien. Das thermoelektrische Material wird mit einem Sprühverfahren aufgetragen.

Hiervon ausgehend ist es Aufgabe der hier vorliegenden Erfindung, die im Zusammenhang mit dem Stand der Technik geschilderten Probleme zumindest teilweise zu lösen. Insbesondere soll das Verfahren zur Herstellung rohrförmiger thermoelektrischer Module vereinfacht werden, indem die Teileanzahl reduziert und die bisher nötige Abstimmung der einzelnen Toleranzen reduziert oder sogar vermieden werden kann.

Diese Aufgaben werden gelöst mit einem Verfahren zur Herstellung eines Bauelements für ein thermoelektrisches Modul gemäß den Merkmalen des Patentanspruchs 1. Vorteilhafte Ausgestaltungen der Erfindung sowie die Integration der (so hergestellten) Bauelemente in übergeordnete Baueinheiten (wie z. B. einem thermoelektrischen Modul oder einem thermoelektrischen Generator) sind in den abhängig formulierten Patentansprüchen angegeben. Die in den Patentansprüchen einzeln aufgeführten Merkmale sind in beliebiger, technologisch sinnvoller Weise miteinander kombinierbar und zeigen weitere Ausgestaltungen der Erfindung auf. Damit ist insbesondere gemeint, dass die auf den Faden gerichteten Erläuterungen gleichermaßen für das angeführte Verfahren zur Herstellung eines Bauelements wie auch für das thermoelektrische Modul anwendbar sind und umgekehrt. Die Beschreibung, insbesondere im Zusammenhang mit den Figuren, erläutert die Erfindung und führt weitere Ausführungsbeispiele der Erfindung an.

Der Faden hat eine Erstreckung und weist zumindest teilweise einen thermoelektrischen Werkstoff auf. Die Erstreckung beschreibt insbesondere die Länge des Fadens, wobei der Faden weiterhin durch einen Durchmesser beschrieben ist, der als (größter) Durchmesser eines Querschnitts des Fadens definiert ist.

Der Faden ist insbesondere (ohne den thermoelektrischen Werkstoff) leicht verformbar, wickelbar, etc. Der Faden kann einteilig oder mehrteilig (z. B. mit mehreren Fasern/Filamenten) ausgeführt sein. Falls der Faden mehrteilig ausgeführt ist, kann dies in Abschnitten auch verschieden erfolgen, z. B. indem die Anzahl und/oder Anordnung der Fasern/Filamente in verschiedenen Fadensektoren/Abschnitten unterschiedlich ist.

Der Faden weist insbesondere eine Erstreckung auf, die im technischen Sinn als endlos zu bezeichnen ist. Endlos bedeutet hier, dass der Faden eine solche Erstreckung aufweist, dass er bei der Verwendung in einem Herstellungsverfahren für ein (thermoelektrisches) Bauelement regelmäßig abgelängt wird. Insbesondere beträgt die Erstreckung mindestens 50 mm [Millimeter], insbesondere mindestens 500 mm und bevorzugt mehr als 1.000 mm.

In einem Faden können auch Fasern aus unterschiedlichen Werkstoffen eingesetzt werden. Bevorzugt ist der Faden zumindest teilweise durch mindestens einen Werkstoff der Gruppe
- keramischer Werkstoff,
- Glasfaserwerkstoff,
- Kohlefaser,
- metallischer Werkstoff,
- thermoelektrischer Werkstoff
gebildet. Durch die Auswahl des Werkstoffs einer Faser können die Eigenschaften des Fadens, insbesondere in den einzelnen Abschnitten, anwendungsorientiert eingestellt werden. Der Faden kann somit insbesondere die folgenden Eigenschaften (allein oder auch in Kombination) aufweisen: thermoelektrisch, elektrisch leitend, elektrisch isolierend, thermisch leitend, thermisch isolierend, abdichtend, und/oder hohe mechanische Festigkeit.

Als thermoelektrischer Werkstoff kommen insbesondere folgende Werkstoffe zum Einsatz:

| Typ: | Material: |
|---|---|
| V-VI | Bi₂Te₃ |
| IV-VI | PbTe |
| Zn₄Sb₃ | Zn₄Sb₃ |
| Silizide | p-MnSi_{1.73} ; n-Mg₂Si_{0,4}Sn_{0,6} ; Si_{0,80}Ge_{0,20} ; Si_{0,94}Ge_{0,06} |
| Skutterutide | CoSb3 |
| Halb-Heusler | TiNiSn |
| n/p-Klathrate | Ba₈Ga₁₆Ge₃₀ |
| Oxide | p-NaCo₂O₄ |
| Zintl-Phasen | p-Yb₁₄MnSb₁₁ |
| Th₃P₄ | La₃₋ₓTe₄ |

Gemäß einer bevorzugten Ausgestaltung weist der Faden entlang der Erstreckung unterschiedliche thermoelektrische Werkstoffe auf. Mit anderen Worten heißt das insbesondere, dass in Richtung der Erstreckung (hintereinander bzw. aneinander angrenzend) mindestens zwei Fadensektoren ausgebildet sind, die verschiedene thermoelektrische Werkstoffe aufweisen. Dies gilt insbesondere für den Fall, dass der Faden noch als Ausgangselement für die Herstellung des thermoelektrischen Bauteils vorliegt, also insbesondere nachfolgend noch zwischen den Fadensektoren zerteilt wird. Insbesondere unterscheiden sich diese unterschiedlichen thermoelektrischen Werkstoffe hinsichtlich der temperaturabhängigen Effektivitätsmaxima. Jeder thermoelektrische Werkstoff weist eine charakteristische optimale Einsatztemperatur auf, bei der ein maximaler Wirkungsgrad hinsichtlich der Umwandlung von thermischer Energie in elektrische Energie erreicht wird. Es ist möglich, dass die thermoelektrischen Werkstoffe der Fadensektoren unterschiedlich dotiert sind.

Insbesondere weist der Faden entlang der Erstreckung auch nichtthermoelektrischen Werkstoff auf. Insbesondere bedeutet dies, dass entlang der Erstreckung Abschnitte vorgesehen sind, die ausschließlich durch nichtthermoelektrischen Werkstoff gebildet werden. Insbesondere weist der Faden mehrere Abschnitte mit zumindest teilweise abwechselnd thermoelektrischem Werkstoff und nichtthermoelektrischem Werkstoff auf.

Gemäß einer besonders vorteilhaften Ausgestaltung des Fadens ist dieser entlang der Erstreckung mit dem Werkstoff (thermoelektrischer Werkstoff, nichtthermoelektrischer Werkstoff) (zusätzlich) beschichtet. Damit ist insbesondere gemeint, dass in dem Faden bzw. auf der Fadenoberfläche eine Beschichtung vorgesehen ist, die den thermoelektrischen Werkstoff und/oder den nicht-thermoelektrischer Werkstoff umfasst. Soweit verschiedene Werkstoffe bei einem (einzelnen) Faden vorgesehen sind, sind diese Beschichtungen regelmäßig nicht übereinander sondern nebeneinander vorgesehen. Die Schichtdicke kann ebenfalls variieren, dies ist aber nicht zwingend erforderlich. Bevorzugt ist, dass die Schichtdicke ausgehend von der Fadenoberfläche so bemessen ist, dass eine geschlossene Oberflächenschicht gebildet ist, der Faden aber mit der (ggf. noch nicht fest fixierten) Beschichtung noch verformt werden kann.

Insbesondere weist der Faden mindestens eine Faser auf, insbesondere eine Faser mit einer Zugfestigkeit Rₘ von mindestens 200 N/mm².

Bevorzugt ist zudem, dass wenigstens eine der Fasern des Fadens mit mindestens einem Werkstoff aus der Gruppe:
- thermoelektrischer Werkstoff,
- nichtthermoelektrischer Werkstoff,
- elektrisch isolierender Werkstoff,
- elektrisch leitender Werkstoff,
- thermisch isolierender Werkstoff,
- thermisch leitender Werkstoff,
- abdichtender Werkstoff (gegenüber Gas und/oder Flüssigkeiten)
beschichtet ist. Die relativ angegebenen Eigenschaften bzw. Werkstoffkenndaten sind auf das eingesetzte thermoelektrische Material bezogen, dass zur Umwandlung thermischer in elektrische Energie eingesetzt wird. Das bedeutet insbesondere, dass "elektrisch isolierend" heißt, dass die elektrische Leitfähigkeit des Werkstoffs geringer ist als die elektrische Leitfähigkeit des thermoelektrischen Werkstoffs. Gleiches gilt für "elektrisch leitend" (in diesem Fall nur höher), "thermisch isolierend", "thermisch leitend" und "abdichtend".

Insbesondere weist der Faden in unterschiedlichen Abschnitten unterschiedliche Beschichtungen auf, insbesondere mit mindestens einem Werkstoff der vorstehend angegebenen Gruppe. In einzelnen Abschnitten sind auch Kombinationen dieser Eigenschaften bzw. Werkstoffe möglich. Insbesondere können Abschnitte vorgesehen sein, in denen ein Werkstoff, der sowohl elektrisch isolierend als auch thermisch isolierend ist, als Beschichtung vorliegt.

Insbesondere weist der Faden eine Mehrzahl von Fasern auf, die miteinander verdrillt sind. Die Anzahl der Fasern kann beispielsweise 2 bis 30 betragen, wobei die Verwendung von 2 bis 10 Fasern bevorzugt ist.

Eine verdrillte Anordnung der Fasern liegt insbesondere dann vor, wenn die Fasern entlang ihrer Erstreckung aneinander liegen und einander umschlingen. Unter einer Verdrillung wird insbesondere das gegeneinander Verwinden und/oder das schraubenförmige Umeinanderwickeln von Fasern verstanden.

Bevorzugt werden wenigstens zwei Arten von Fasern mit unterschiedlichen Eigenschaften in gleichen Abschnitten des Fadens miteinander verdrillt. So können Fasern mit thermoelektrischen Eigenschaften mit Fasern, die nichtthermoelektrische und thermisch isolierende sowie elektrisch isolierende Eigenschaften aufweisen, kombiniert werden. Der Faden kann insbesondere durch Fasern mit hoher mechanischer Festigkeit verstärkt werden.

Gemäß einer besonders vorteilhaften Ausgestaltung des Fadens weist der Faden Hohlräume auf. Die Hohlräume können z. B. nach Art von Poren ausgeführt sein. Dabei können die Hohlräume abgeschlossen und/oder miteinander verbunden sein. Regelmäßig werden die Hohlräume wenigstens teilweise von dem Werkstoff des Fadens bzw. der Faser gebildet/begrenzt. Die Hohlräume können zwischen Fasern und/oder in den Fasern ausgebildet sein.

Insbesondere sind die Hohlräume zumindest teilweise mit mindestens einem Werkstoff aus der Gruppe:
- thermoelektrischer Werkstoff,
- nichtthermoelektrischer Werkstoff,
- elektrisch isolierender Werkstoff,
- elektrisch leitender Werkstoff,
- thermisch isolierender Werkstoff,
- thermisch leitender Werkstoff
- abdichtender Werkstoff (gegenüber Gas und/oder Flüssigkeiten)
gefüllt.

Bevorzugt weist der Faden zumindest in einer radialen Richtung oder in der Richtung der Erstreckung unterschiedliche Werkstoffkenndaten auf. Somit kann der Faden auch in beiden Richtungen unterschiedliche Werkstoffkenndaten aufweisen. Insbesondere werden unterschiedliche Werkstoffkenndaten durch den Einsatz unterschiedlicher Werkstoffe und durch den unterschiedlichen Aufbau des Fadens und/oder durch eine unterschiedliche Behandlung während der Herstellung des Fadens erzeugt. Eine solche Behandlung kann z. B. eine thermische Behandlung und/oder eine Behandlung durch Druck oder ähnliches umfassen (z. B. Sinterverfahren).

Gemäß einer besonders vorteilhaften Ausgestaltung weist der Faden insbesondere in Richtung der Erstreckung unterschiedliche Querschnittsflächen auf. "Unterschiedlich" heißt hier, dass sich der Durchmesser bzw. die Größe der Querschnittsfläche in Richtung der Erstreckung verändert. Diese Veränderung kann stufenweise und/ oder kontinuierlich erfolgen. Durch diese unterschiedlichen Querschnittsflächen können auch sehr dünne Schichten auf dem thermoelektrischen Modul erzeugt werden, so dass insbesondere auch das gesamte thermoelektrische Modul zumindest teilweise aus einem oder mehreren der vorgeschlagenen Fäden herstellbar ist.

Insbesondere ist der Faden auf einer Außenumfangsfläche einer rohrförmigen Aufnahme in einer, in einer radialen Richtung, mehrlagigen Umwicklung aufwickelbar und kann so mindestens ein ringförmiges, n- oder p-dotiertes thermoelektrisches Halbleiterelement bilden, das zusammen mit anderen ringförmigen Bauelementen zwischen einer äußeren Hülle und einer inneren Hülle eines rohrförmigen thermoelektrisches Modul anordenbar ist.

Der Faden wird nun ergänzend im Zusammenhang mit einem bevorzugten Verfahren zur Herstellung eines Bauelements für ein thermoelektrisches Modul eingesetzt.

Das erfindungsgemäße Verfahren zur Herstellung eines Bauelements eines thermoelektrischen Moduls weist zumindest die folgenden Schritte auf:
a) Bereitstellen mindestens eines Fadens mit einer Erstreckung,
b) Applizieren von thermoelektrischem Werkstoff zu dem mindestens einen Faden,
c) Bereitstellen einer rohrförmigen Aufnahme mit einer Außenumfangsfläche,
d) Wickeln des mindestens einen Fadens um die rohrförmige Aufnahme, so dass auf der Außenumfangsfläche mindestens ein ringförmiges Bauelement für ein thermoelektrisches Modul gebildet wird, das mit anderen ringförmigen Bauelementen zwischen einer äußeren Hülle und einer inneren Hülle eines rohrförmigen thermoelektrischen Moduls anordenbar ist.

Als Bauelement für ein thermoelektrisches Modul ist insbesondere ein ringförmiges thermoelektrisches Halbleiterelement zu nennen. Mehrere solcher, n-dotierter und p-dotierter Halbleiterelemente werden später wechselweise hintereinander angeordnet und mit entsprechender elektrischer Verschaltung zu einem rohrförmigen thermoelektrischen Modul verbaut. Die wechselweise elektrische Verschaltung ermöglicht, dass ein an dem thermoelektrischen Modul anliegendes Temperaturpotential in einen elektrischen Strom umgewandelt werden kann. Zusätzlich zu den thermoelektrischen Bauelementen können auch elektrisch isolierende bzw. thermisch isolierende ringförmige Bauelemente erzeugt werden, die zwischen den thermoelektrischen Bauelementen angeordnet sind. Weiterhin können auch elektrisch leitende wie auch thermisch leitende Bauelemente erzeugt werden, die z. B. zur elektrisch leitenden Verbindung der einzelnen thermoelektrischen Bauelemente eingesetzt werden.

Das Verfahren eignet sich insbesondere dazu, zumindest einzelne Bauelemente für ein thermoelektrisches Modul zu erzeugen und insbesondere auch ein gesamtes thermoelektrisches Modul mit einem einzelnen oder mit mehreren Fäden nacheinander und/oder parallel herzustellen. Insbesondere wird ein (endloser) Faden bereitgestellt, der in gleichen und/oder einzelnen Abschnitten unterschiedliche Werkstoffe und/oder unterschiedliche Eigenschaften aufweist.

Die Eigenschaften des Fadens können z. B. sein:
- thermoelektrische Eigenschaft zur Umwandlung eines Temperaturpotentials in einen elektrischen Strom,
- elektrisch isolierend, also geringere elektrische Leitfähigkeit [Ampere/ (Volt * Meter)] als der thermoelektrische Werkstoff,
- elektrisch leitend, also höhere elektrische Leitfähigkeit [Ampere/ (Volt * Meter)] als der thermoelektrische Werkstoff,
- thermisch isolierend, also geringere spezifische Wärmeleitfähigkeit [Watt/(Kelvin * Meter)] als der thermoelektrische Werkstoff,
- thermisch leitend, also höhere spezifische Wärmeleitfähigkeit [Watt/(Kelvin * Meter)] als der thermoelektrische Werkstoff,
- hohe mechanische Festigkeit (insbesondere Zugfestigkeit mit mehr als 200 N/mm²),
- abdichtend gegenüber Gas und/oder Flüssigkeiten.
Die hier angeführten Definitionen für die Begriffe "elektrisch isolierend", "elektrisch leitend", "thermisch isolierend", "thermisch leitend" gelten nicht nur für die Eigenschaften des Fadens, sondern auch für die Beschichtung, die Faser, die Bauelemente und die in den Hohlräumen angeordneten Werkstoffe.

Grundsätzlich können die Schritte des Verfahrens in der hier mit Buchstaben angedeuteten Reihenfolge durchgeführt werden, dies ist aber nicht zwingend erforderlich. Insbesondere können einige/alle Schritte auch wenigstens zeitgleich erfolgen. So kann der Faden beispielsweise von einer Spule abgezogen (Schritt a)), durch ein Beschichtungsbad hindurch gezogen (Schritt c)), weiter zur Aufnahme geleitet und dort aufgewickelt werden (Schritte b) und d)). Es ist auch möglich, dass der Faden ohne thermoelektrischen Werkstoff auf der Aufnahme positioniert wird und anschließend die Applikation des thermoelektrischen Werkstoffs (z. B. in die so gebildeten Hohlräume) erfolgt. Es ist weiter möglich, den Faden innerhalb eines Beschichtungsbades aufzuwickeln. Darüber hinaus ist auch möglich, dass ggf. Schritte wiederholt durchgeführt werden, wie beispielsweise die Bereitstellung einer Mehrzahl von Fäden und/oder Aufnahmen sowie gegebenenfalls eine wiederholte Applikation von thermoelektrischem Material (zu verschiedenen Abschnitten des Fadens und/oder zu verschiedenen Zeitpunkten).

Schritt d) wird bevorzugt so ausgeführt, dass wenigstens ein Teil der Außenumfangsfläche der Aufnahme von dem thermoelektrischen Werkstoff umfassenden Faden bedeckt ist. Insbesondere wird damit in radialer Richtung nach außen eine mehrlagige Umwicklung mit dem Faden gebildet, so dass die radiale Dicke des ringförmigen Bauteils ein Vielfaches des Fadendurchmessers beträgt. Dabei kann die Umwickelung mit mehreren Fäden und/oder unterschiedlicher Orientierung vorgesehen sein.

Gemäß einer besonders vorteilhaften Ausgestaltung weist die rohrförmige Aufnahme mindestens einen, in einer Umfangsrichtung zumindest teilweise umlaufenden Steg auf, so dass in einer axialen Richtung auf der Außenumfangsfläche der rohrförmigen Aufnahme Taschen gebildet sind, die durch den mindestens einen Faden zumindest teilweise aufgefüllt werden.

Die bereitgestellte rohrförmige Aufnahme stellt insbesondere die innere Hülle eines rohrförmigen thermoelektrischen Moduls dar. Insbesondere ist die rohrförmige Aufnahme aber unabhängig von dem herzustellenden thermoelektrischen Modul, so dass das ringförmige Bauelement von der Aufnahme entfernbar ist. Die rohrförmige Aufnahme dient insbesondere als innere Form für das ringförmige Bauelement, so dass der mindestens eine Faden, ausgehend von der rohrförmigen Aufnahme, das ringförmige Bauelement sukzessive in der radialen Richtung und in der Umfangsrichtung als auch in einer axialen Richtung erzeugt.

Insbesondere sind die Stege mit der rohrförmigen Aufnahme formschlüssig oder auch stoffschlüssig verbunden. Bei einer formschlüssigen Verbindung ist einer der Verbindungspartner einem anderen im Weg, blockiert also dessen Bewegungsmöglichkeit beispielsweise mittels eines Eingriffs. Stoffschlüssige Verbindungen werden alle Verbindungen genannt, bei denen die Verbindungspartner durch atomare oder molekulare Kräfte zusammengehalten werden. Insbesondere werden die Stege, je nach Fortschritt des Wickelns in der axialen Richtung, sukzessive auf die rohrförmige Aufnahme aufgebracht.

Zwischen den einzelnen Stegen werden Taschen gebildet, die insbesondere die einzelnen, durch das Verfahren hergestellten ringförmigen Bauelemente in der axialen Richtung voneinander trennen.

Insbesondere können mehrere auch unterschiedliche Fäden eingesetzt werden, die in unterschiedlichen oder auch gleichen Taschen nacheinander oder gleichzeitig ringförmige Bauelemente erzeugen.

Gemäß einer besonderen Ausgestaltung des Verfahrens werden mehrere Fäden bereitgestellt, die gleichzeitig in einem Schritt d) auf die rohrförmige Aufnahme aufgebracht werden. Hierbei können die mehreren Fäden gleiche oder unterschiedliche Werkstoffe aufweisen. Weiter können die mehreren Fäden zumindest teilweise identisch aufgebaut sein.

Insbesondere können die Stege z. B. durch elektrisch isolierende Fäden erzeugt werden, wobei ggf. gleichzeitig eine thermisch isolierende Eigenschaft des Fadens vorliegt. Es ist auch möglich, dass der eingesetzte Faden in unterschiedlichen Abschnitten entsprechend unterschiedliche Eigenschaften aufweist, so dass an vorher festgelegten Stellen entlang der rohrförmigen Aufnahme thermoelektrische Bauelemente, elektrisch isolierende Bauelemente, elektrisch leitende Bauelemente, thermisch isolierende Bauelemente, thermisch leitende Bauelemente oder dichtende Bauelemente erzeugt werden können. Diese unterschiedlichen Bauelemente können entlang der axialen Richtung und/oder entlang der Umfangsrichtung nebeneinander und/oder in der radialen Richtung übereinander erzeugt und angeordnet werden.

Insbesondere können die so erzeugten Bauelemente auch bereits nach nur teilweiser Erzeugung weiteren Verfahrensschritten zugeführt werden. Diese Verfahrensschritte können z. B. eine Wärmebehandlung und/oder eine Druckbehandlung (z. B. Sinterverfahren) umfassen. Weiterhin können Verfahrensschritte für das Aufbringen einer Beschichtung eingefügt werden.

Insbesondere wird zusätzlich mindestens ein Faden aus einem nicht thermoelektrischen Werkstoff mit aufgewickelt. Dieser kann beispielsweise zur Schaffung von Hohlräumen und/oder zur Einstellung einer gewünschten Festigkeit vorgesehen werden.

Gemäß einer besonders vorteilhaften Ausgestaltung wird Schritt c) zumindest teilweise gleichzeitig und/oder nach Schritt d) ausgeführt.

Der thermoelektrische Werkstoff kann z. B. in Form einer Beschichtung, z. B. durch ein Sprühverfahren oder durch Aufstreichen einer pastös Masse auf das zumindest teilweise hergestellte Bauelement aufgetragen werden. Ggf. schließen sich weitere Verfahrensschritte an und/oder werden zwischenzeitlich ausgeführt (thermische oder Druckbehandlung).

Insbesondere kann für das Verfahren mindestens ein Faden eingesetzt werden, der insbesondere auch in Richtung der Erstreckung unterschiedliche Querschnitte aufweist. Durch diese unterschiedlichen Querschnitte können auch sehr dünne Schichten auf dem thermoelektrischen Modul erzeugt werden, so dass insbesondere auch das gesamte thermoelektrische Modul zumindest teilweise aus einem oder mehreren der vorgeschlagenen Fäden herstellbar ist.

Es wird weiterhin ein rohrförmiges thermoelektrisches Modul vorgeschlagen, zumindest aufweisend eine Kaltseite, eine Heißseite sowie dazwischen angeordnete ringförmige Bauelemente, wobei die Bauelemente mindestens ein Bauelement der Gruppe
- Bauelement umfassend thermoelektrischen Werkstoff,
- Bauelement umfassend elektrisch isolierenden Werkstoff,
- Bauelement umfassend thermisch isolierenden Werkstoff,
- Bauelement umfassend elektrisch leitenden Werkstoff,
- Bauelement umfassend einen abdichtenden Werkstoff,
- Bauelement umfassend einen thermisch leitenden Werkstoff
aufweisen, und wobei weiter das mindestens eine ringförmige Bauelement nach einem hier vorgeschlagenen Verfahren hergestellt wurde.

Ganz besonders bevorzugt ist, dass alle ringförmigen Bauelemente des rohrförmigen thermoelektrischen Moduls mit einem solchen Bauelement aufweisend einen Faden ausgebildet sind. Das rohrförmige thermoelektrische Modul hat dabei bevorzugt einen innen liegenden Kanal und eine äußere Zylinderoberfläche, die jeweils entweder von einem heißen oder einem kalten Medium umströmt werden können, so dass die dazwischen angeordneten ringförmigen Bauelemente innen und außen einem verschiedenen Temperaturpotential ausgesetzt sind (Heißseite, Kaltseite).

Die Erfindung sowie das technische Umfeld werden nachfolgend anhand der Figuren näher erläutert. Die Figuren zeigen besonders bevorzugte Ausführungsbeispiele, auf die die Erfindung jedoch nicht begrenzt ist. Gleiche Gegenstände in den einzelnen Figuren werden mit gleichen Bezugszeichen bezeichnet. Es zeigen schematisch:
- Fig. 1:: einen Faden mit einer Erstreckung;
- Fig. 2:: einen Faden im Längsschnitt;
- Fig. 3:: den Faden aus Fig. 2 im Querschnitt;
- Fig. 4:: einen weiteren Faden im Querschnitt;
- Fig. 5:: den Verfahrensschritt a);
- Fig. 6:: den Verfahrensschritt b);
- Fig. 7:: Verfahrensschritte c) und d);
- Fig. 8:: eine Aufnahme mit Stegen nach Verfahrensschritt d);
- Fig. 9:: ein thermoelektrisches Modul; und

- Fig. 10:: einen Faden mit sich ändernder Querschnittsfläche entlang einer Erstreckung.

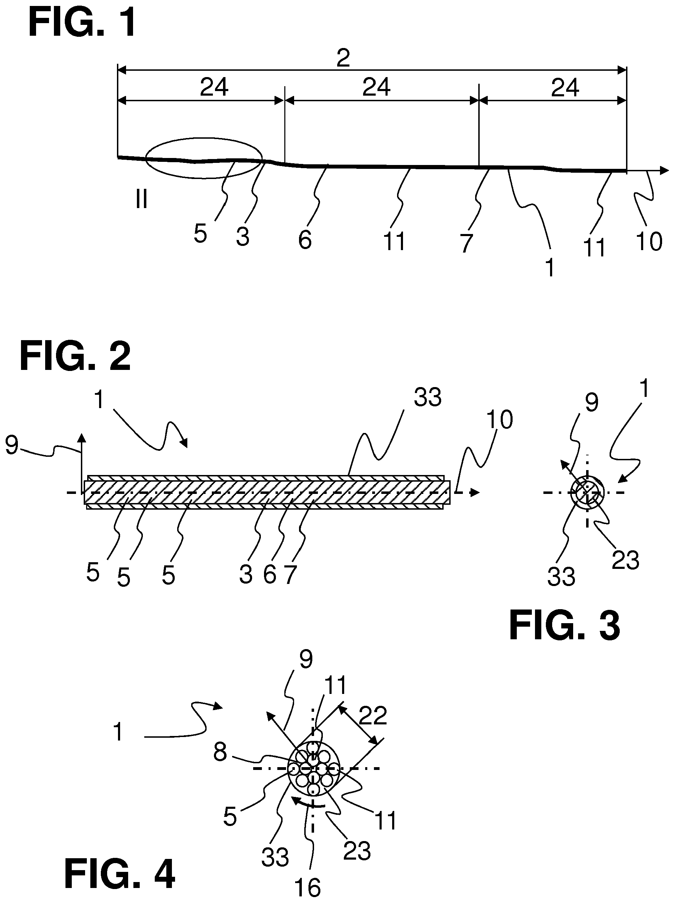

Fig. 1 zeigt einen Faden 1 mit einer Erstreckung 2. Entlang der Erstreckung 2 ist der Faden 1 in mehrere Abschnitte 24 (oder Fadensektoren) unterteilt, die sich entlang der Richtung der Erstreckung 10 aneinander anschließen. Im linken Abschnitt 24 weist der Faden 1 einen thermoelektrischen Werkstoff 3 auf. Im mittleren Abschnitt 24 weist der Faden 1 einen elektrisch isolierenden Werkstoff 6 auf. Im rechten Abschnitt 24 weist der Faden 1 einen thermisch isolierenden Werkstoff 7 auf. In den unterschiedlichen Abschnitten 24 können unterschiedliche Werkstoffkenndaten 11 vorliegen. Der Faden 1 besteht aus mindestens einer Faser 5. Im linken Abschnitt 24 ist ein Ausschnitt II gekennzeichnet.

Fig. 2 zeigt den Ausschnitt II aus Fig. 1 und den Faden 1 (zur Veranschaulichung vergrößert) im Längsschnitt. Der Faden 1 erstreckt sich in Richtung der Erstreckung 10 und wird durch mehrere miteinander verdrillte Fasern 5 gebildet. Insbesondere weisen die einzelnen Fasern 5 unterschiedliche Eigenschaften auf. Hier wird der Faden 1 durch Fasern 5 aus thermoelektrischem Werkstoff 3, aus elektrisch isolierendem Werkstoff 6 und aus thermisch isolierendem Werkstoff 7 gebildet. Die Fasern 5 sind weiterhin mit einer Beschichtung 33 versehen.

Fig. 3 zeigt den Faden 1 aus Fig. 2 im Querschnitt 23. Der Faden 1 weist eine Beschichtung 33 auf, die die Fasern 5 des Fadens 1 in radialer Richtung 9 außen (vollständig) umgibt.

Fig. 4 zeigt einen weiteren Faden 1 im Querschnitt 23. Der Faden weist einen (größten) Durchmesser 22 auf. Der Faden 1 wird gebildet durch mehrere Fasern 5, die im Querschnitt 23 nebeneinanderliegend angeordnet sind. Durch die Fasern 5 werden Hohlräume 8 gebildet, die hier durch eine Beschichtung 33 aufgefüllt sind. Die Fasern 5 weisen unterschiedliche Werkstoffkenndaten 11 auf, so dass in Umfangsrichtung 16 und auch in radialer Richtung 9 der Faden 1 unterschiedliche Werkstoffkenndaten 11 aufweist.

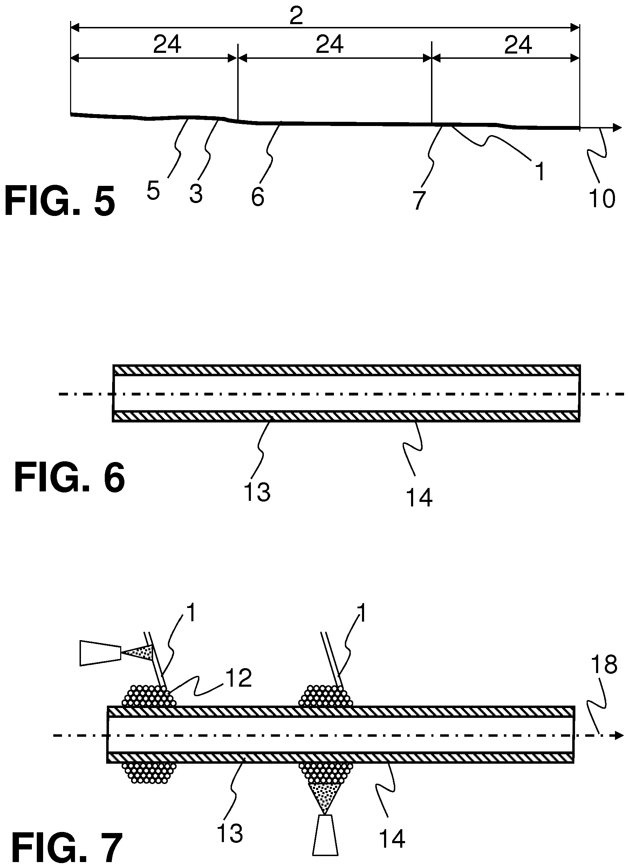

Fig. 5 zeigt den Schritt a) des Verfahrens, wobei ein Faden 1 mit einer Erstreckung 2 bereitgestellt wird. Es ist erkennbar, dass der Faden 1 entlang der Richtung der Erstreckung 10 in unterschiedliche Abschnitte 24 aufgeteilt ist. In diesen Abschnitten 24 weist der Faden 1 jeweils unterschiedliche Eigenschaften auf. In einem Abschnitt 24 weist der Faden 1 einen thermoelektrischen Werkstoff 3 auf, in anderen Abschnitten 24 einen elektrisch isolierenden Werkstoff 6 und einen thermisch isolierenden Werkstoff 7.

Fig. 6 zeigt den Schritt b) des Verfahrens, wobei eine rohrförmige Aufnahme 13 mit einer Außenumfangsfläche 14 bereitgestellt ist.

Fig. 7 zeigt Verfahrensschritte c) und d), wobei mehrere Fäden 1 um die rohrförmige Aufnahme 13 gewickelt werden, so dass auf der Außenumfangsfläche 14 der Aufnahme 13 ein ringförmiges Bauelement 12 gebildet wird. Die ringförmigen Bauelemente 12 sind in der axialen Richtung 18 hintereinander angeordnet.

Die Applikation des thermoelektrischen Materials kann nun vor, während und/oder nach dem Aufwickeln erfolgen, wie dies hier beispielsweise durch einen Sprühprozess zu verschiedenen Zeitpunkten angedeutet ist.

Insbesondere können zusätzliche Verfahrensschritte vorgesehen werden, die insbesondere Sinterverfahrensschritte mit erhöhter Temperatur und/oder erhöhtem Druck einschließen. Das heißt beispielsweise, dass die Anordnung, wie sie nun vorliegt, einem Sinterprozess zugeführt werden kann, wobei die Fadenanordnung zusammen mit dem Werkstoff ggf. verdichtet, ausgehärtet und/oder thermisch behandelt wird. Dabei können die Taschen ggf. auch getrennt und separat behandelt werden.

Selbstverständlich fällt dem Fachmann sofort auf, dass hier weitere (untergeordnete) Prozesse integriert werden können, wie z. B. das Ablängen des Fadens, das Zerlegen der rohrförmige Aufnahme, und dergleichen.

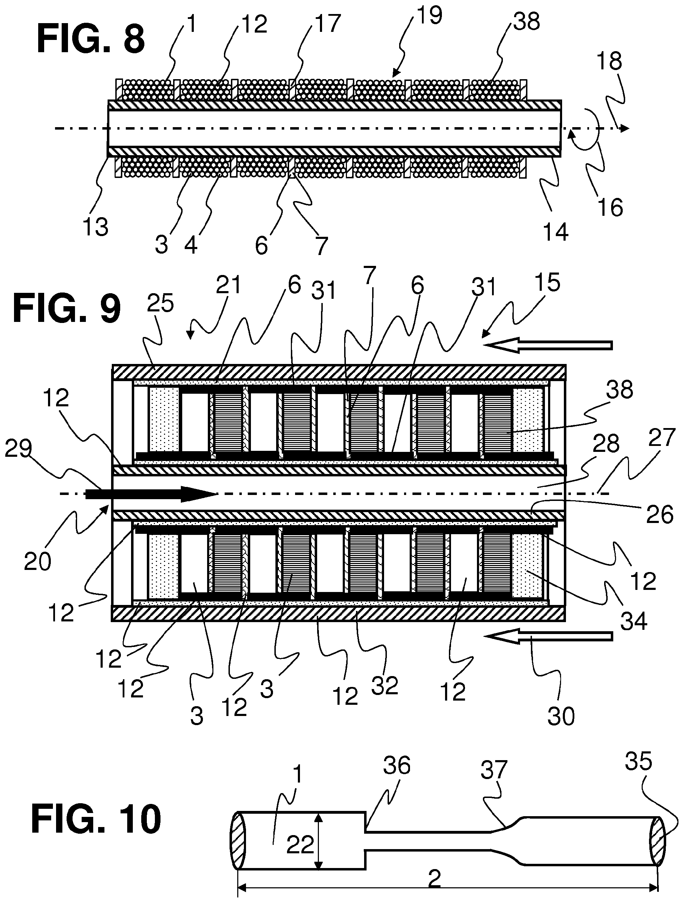

Fig. 8 zeigt eine rohrförmige Aufnahme 13 mit Stegen 17, die sich in einer Umfangsrichtung 16 um die rohrförmige Aufnahme 13 erstrecken. Durch die Stege 17 werden Taschen 19 zwischen den Stegen 17 und auf der Außenumfangsfläche 14 gebildet, die durch den Faden 1 zumindest teilweise aufgefüllt werden. Die Stege 17 sind hier aus einem elektrisch isolierenden Werkstoff 6 hergestellt, so dass die durch den Faden 1 erzeugten ringförmigen Bauelemente 12 aus thermoelektrischem Werkstoff 3 in der axialen Richtung 18 voneinander elektrisch isoliert angeordnet werden können. Dabei liegt in benachbarten Taschen 19 insbesondere n-dotierter und p-dotierter thermoelektrischer Werkstoff 3 vor, so dass in den Taschen 19 ringförmige n-dotierte und p-dotierte Halbleiterelemente (38) gebildet sind.

Hier ist weiter dargestellt, dass in den Taschen 19 neben dem thermoelektrischen Werkstoff 3 auch nichtthermoelektrischer Werkstoff 4 vorliegt. Insbesondere hat dieser nichtthermoelektrische Werkstoff 4 eine geringere elektrische Leitfähigkeit als der thermoelektrische Werkstoff 3 und ebenso eine geringere thermische Leitfähigkeit. Durch die Kombination von thermoelektrischem Werkstoff 3 und nichtthermoelektrischem Werkstoff 4 kann der sog. "Füllgrad" des ringförmigen Bauelements 12 beeinflusst werden. In Bezug auf den Füllgrad wird auf die DE 10 2010 030 259 A1 verwiesen, die hiermit vollumfänglich in Bezug genommen wird. In Bezug auf den Füllgrad wird dort ausgeführt, dass die Effektivität eines thermoelektrischen Moduls nicht allein durch einen möglichst großen Anteil an thermoelektrischem Werkstoff zwischen einer Heißseite und einer Kaltseite gesteigert wird, sondern auch durch die Aufrechterhaltung eines maximalen Temperaturpotentials zwischen Heiß- und Kaltseite.

Die erzeugbare elektrische Leistung des thermoelektrischen Moduls ergibt sich vereinfacht ausgedrückt aus dem Produkt des thermoelektrischen Wirkungsgrades des Moduls und dem auf der heißeren Seite des thermoelektrischen Moduls eintretenden Wärmestrom Q. Im Allgemeinen steigt der thermoelektrische Wirkungsgrad mit steigendem thermischen Widerstand der funktionalen Schicht zwischen der Heißseite und der Kaltseite, da dadurch die Temperaturdifferenz zwischen der Heißseite und der Kaltseite steigt. Dem entgegen sinkt der fließende Wärmestrom durch den erhöhten thermischen Widerstand. Das bedeutet insbesondere, dass die elektrische Leistung eine Funktion des thermischen Widerstands des thermoelektrischen Moduls ist. Der thermische Widerstand des thermoelektrischen Moduls ergibt sich aus der Wärmeleitfähigkeit des Halbleiterelements (hier also thermoelektrischer Werkstoff 3 und nichtthermoelektrischer Werkstoff 4), den geometrischen Abmessungen der Halbleiterelemente, der Wärmeleitfähigkeit der zwischen den Halbleiterelementen angeordneten elektrischen Isolation (z. B. hier die Stege 17) sowie deren geometrischen Abmessungen.

Fig. 9 zeigt ein rohrförmiges thermoelektrisches Modul 15, das durch eine innere Hülle 26 und eine äußere Hülle 25 gebildet wird. Das rohrförmige thermoelektrische Modul 15 erstreckt sich entlang einer Mittelachse 27 und weist einen Kanal 28 innerhalb der inneren Hülle 26 auf. Hier ist dargestellt, dass der Kanal 28 von einem Kühlmittel 29 durchströmt wird und dass die äußere Hülle 25 von einem heißen Fluid 30 überströmt wird. Damit ist an der äußeren Hülle 25 die Heißseite 21 und entsprechend an der inneren Hülle 26 die Kaltseite 20 des thermoelektrischen Moduls 15 gebildet. Es ist jedoch ebenfalls erfindungsgemäß diese Anordnung umzukehren.

Zwischen innerer Hülle 26 und äußerer Hülle 25 sind ringförmige Bauelemente 12 aus zumindest thermoelektrischem Werkstoff 3 angeordnet, die durch elektrisch leitenden Werkstoff 31 wechselweise miteinander verbunden sind. Neben den ringförmigen Bauelementen 12 aus thermoelektrischem Werkstoff 3 (und ggf. zusätzlich nichtthermoelektrischem Werkstoff 4) können auch insbesondere alle anderen Bauteile des thermoelektrischen Moduls 15 durch entsprechend hergestellte ringförmige Bauelemente 12 gebildet sein. Dies gilt insbesondere für die äußere Hülle 25 und die innere Hülle 26, die bevorzugt aus thermisch leitendem Werkstoff 32 gebildet sind, für den elektrisch isolierenden Werkstoff 6 an der äußeren Hülle 25 und an der inneren Hülle 26, den elektrisch und thermisch isolierenden Werkstoff 6, 7 zwischen den thermoelektrischen Werkstoffen 3 (den Halbleiterelementen 38), den das thermoelektrische Modul 15 nach außen abdichtenden Werkstoff 34 und den elektrisch leitenden Werkstoff 31, der die ringförmigen Bauelemente 12 aus thermoelektrischem Werkstoff 3 wechselweise miteinander verbindet.

Fig. 10 zeigt einen Faden 1 mit sich ändernder Querschnittsfläche 35 entlang einer Erstreckung 2. Dabei verändert sich der Durchmesser 22 bzw. die Größe der Querschnittsfläche 35 entlang der Erstreckung 2 in Stufen 36 oder in Form einer kontinuierlichen Veränderung 37.

Durch den Einsatz des angegebenen Fadens wird ein neuartiges Herstellungsverfahren für ringförmige Bauelemente und für thermoelektrische Module vorgeschlagen. Diese thermoelektrischen Module lassen sich kostengünstig und ohne großen apparativen Aufwand herstellen, da Bauteiltoleranzen hier nur in geringem Maße zu berücksichtigen sind.

Durch den Einsatz eines Fadens werden insbesondere Belastungen in Umfangsrichtung eines thermoelektrischen Moduls, also insbesondere auch Spannungen induziert durch Wärmeausdehnungen, besser kompensiert bzw. ohne Versagen ertragen. Der in Umfangsrichtung gewickelte Faden erzeugt eine hohe mechanische Festigkeit der einzelnen ringförmigen Bauteile und auch des so erzeugten thermoelektrischen Moduls.

Die ringförmigen Bauelemente sind nicht begrenzt auf eine kreisrunde oder ovale Bauform, sondern es sind gleichermaßen auch mehreckige z. B. quaderförmige Bauteile herstellbar. Insbesondere lassen sich die erfindungsgemäß hergestellten ringförmigen Bauteile mit konventionell aus Sintermaterial oder Vollmaterial hergestellten ringförmigen Bauelementen kombinieren.

### Bezugszeichenliste

- 1: Faden
- 2: Erstreckung
- 3: Thermoelektrischer Werkstoff
- 4: Nichtthermoelektrischer Werkstoff
- 5: Faser
- 6: Elektrisch isolierender Werkstoff
- 7: Thermisch isolierender Werkstoff
- 8: Hohlraum
- 9: Radiale Richtung
- 10: Richtung der Erstreckung
- 11: Werkstoffkenndaten
- 12: Bauelement
- 13: Aufnahme
- 14: Außenumfangsfläche
- 15: Thermoelektrisches Modul
- 16: Umfangsrichtung
- 17: Steg
- 18: Axiale Richtung
- 19: Tasche
- 20: Kaltseite
- 21: Heißseite
- 22: Durchmesser
- 23: Querschnitt
- 24: Abschnitt
- 25: Äußere Hülle
- 26: Innere Hülle
- 27: Mittelachse
- 28: Kanal
- 29: Kühlmittel
- 30: Heißes Fluid
- 31: Elektrisch leitender Werkstoff
- 32: Thermisch leitender Werkstoff
- 33: Beschichtung
- 34: abdichtender Werkstoff
- 35: Querschnittsfläche
- 36: Stufe
- 37: Kontinuierliche Veränderung
- 38: Halbleiterelement

## Patentansprüche

1. Verfahren zur Herstellung eines Bauelements (12) für ein thermoelektrisches Modul (15), zumindest aufweisend die folgenden Schritte:
a) Bereitstellen mindestens eines Fadens (1) mit einer Erstreckung (2),
b) Bereitstellen einer rohrförmigen Aufnahme (13) mit einer Außenumfangsfläche (14),
c) Applizieren von thermoelektrischem Werkstoff (3) zu dem mindestens einen Faden (1),
d) Wickeln des mindestens einen Fadens (1) um die rohrförmige Aufnahme (13), **dadurch gekennzeichnet dass** auf der Außenumfangsfläche (14) mindestens ein ringförmiges Bauelement (12) für ein thermoelektrisches Modul (15) gebildet wird, dass mit anderen ringförmigen Bauelementen (12) zwischen einer äußeren Hülle und einer inneren Hülle eines rohrförmigen thermoelektrischen Moduls anordenbar ist.

2. Verfahren nach Patentanspruch 1, wobei die rohrförmige Aufnahme (13) mindestens einen, in einer Umfangsrichtung (16) zumindest teilweise umlaufenden Steg (17) aufweist, so dass in einer axialen Richtung (18) auf der Außenumfangsfläche (14) der rohrförmigen Aufnahme (13) Taschen (19) gebildet sind, die durch den mindestens einen Faden (1) zumindest teilweise aufgefüllt werden.

3. Verfahren nach einem der Patentansprüche 1 oder 2, wobei mehrere Fäden (1) bereitgestellt werden, die gleichzeitig in einem Schritt d) auf die rohrförmige Aufnahme (13) aufgebracht werden.

4. Verfahren nach einem der vorhergehenden Patentansprüche, wobei mindestens ein Faden (1) aus einem nichtthermoelektrischen Werkstoff (4) mit aufgewickelt wird.

5. Verfahren nach einem der vorhergehenden Patentansprüche, wobei Schritt c) zumindest teilweise gleichzeitig oder nach Schritt d) ausgeführt wird.

6. Verfahren nach einem der vorhergehenden Patentansprüche, wobei der mindestens eine Faden (1) entlang der Erstreckung (2) zumindest unterschiedliche thermoelektrische Werkstoffe (3) oder nichtthermoelektrischen Werkstoff (4) aufweist.

7. Verfahren nach einem der vorhergehenden Patentansprüche, wobei der mindestens eine Faden (1) entlang der Erstreckung (2) mit einem Werkstoff (3, 4) beschichtet ist.

8. Verfahren nach einem der vorhergehenden Patentansprüche, wobei der Faden (1) zumindest eine der folgenden Eigenschaften aufweist:
- mindestens eine Faser (5), die eine Zugfestigkeit von mindestens 200 N/mm² aufweist;
- eine Mehrzahl von Fasern (5), die miteinander verdrillt sind;
- zumindest in einer radialen Richtung (9) oder in der Richtung der Erstreckung (10) unterschiedliche Werkstoffkenndaten (11);
- Hohlräume (8), wobei die Hohlräume (8) zumindest teilweise mit mindestens einem Werkstoff aus der folgenden Gruppe gefüllt sind:
∘ thermoelektrischer Werkstoff (3),
∘ elektrisch isolierender Werkstoff (6),
∘ elektrisch leitender Werkstoff (31),
∘ thermisch isolierender Werkstoff (7),
∘ thermisch leitender Werkstoff (32),
∘ abdichtender Werkstoff (34).

9. Verfahren nach einem der vorhergehenden Patentansprüche, wobei der Faden (1) in Richtung der Erstreckung (2) unterschiedliche Querschnittsflächen (35) aufweist.

10. Rohrförmiges thermoelektrisches Modul (15), zumindest aufweisend eine Kaltseite (20), eine Heißseite (21) sowie dazwischen angeordnete ringförmige Bauelemente (12), wobei die Bauelemente (12) mindestens ein Bauelement (12) der Gruppe
- Bauelement (12), umfassend thermoelektrischen Werkstoff (3),
- Bauelement (12), umfassend elektrisch isolierenden Werkstoff (6),
- Bauelement (12), umfassend thermisch isolierenden Werkstoff (7)
- Bauelement (12), umfassend elektrisch leitenden Werkstoff (31),
- Bauelement (12), umfassend thermisch leitenden Werkstoff (32),
- Bauelement (12), umfassend abdichtenden Werkstoff (34) aufweisen, **dadurch gekennzeichnet dass** das mindestens eine ringförmige Bauelement (12) mit einem Verfahren nach einem der Patentansprüche 1 bis 9 hergestellt wurde.

## Claims

1. Method for producing a component (12) for a thermoelectric module (15), at least comprising the following steps:
a) providing at least one thread (1) having an extent (2),
b) providing a tubular receptacle (13) having an outer circumferential surface (14),
c) applying thermoelectric material (3) to the at least one thread (1),
d) winding the at least one thread (1) around the tubular receptacle (13), **characterized in that** at least one annular component (12) for a thermoelectric module (15) is formed on the outer circumferential surface (14), which can be arranged, with other annular components (12), between an outer sleeve and an inner sleeve of a tubular thermoelectric module.

2. Method according to Patent Claim 1, wherein the tubular receptacle (13) has at least one web (17) which is at least partially circumferential in a circumferential direction (16), such that pockets (19), which are at least partially filled by the at least one thread (1), are formed in an axial direction (18) on the outer circumferential surface (14) of the tubular receptacle (13) .

3. Method according to either of Patent Claims 1 and 2, wherein a plurality of threads (1) are provided and are applied simultaneously to the tubular receptacle (13) in a step d).

4. Method according to one of the preceding patent claims, wherein at least one thread (1) made of a non-thermoelectric material (4) is concomitantly wound up.

5. Method according to one of the preceding patent claims, wherein step c) is performed at least partially at the same time as or after step d).

6. Method according to one of the preceding patent claims, wherein the at least one thread (1) comprises at least different thermoelectric materials (3) or non-thermoelectric material (4) along the extent (2).

7. Method according to one of the preceding patent claims, wherein the at least one thread (1) is coated with a material (3, 4) along the extent (2).

8. Method according to one of the preceding patent claims, wherein the thread (1) has at least one of the following properties:
- at least one fiber (5), which has a tensile strength of at least 200 N/mm² ;
- a plurality of fibers (5), which are twisted with one another;
- different material characteristics (11) at least in a radial direction (9) or in the direction of the extent (10) ;
- cavities (8), wherein the cavities (8) are filled at least partially with at least one material selected from the following group:
∘ thermoelectric material (3),
∘ electrically insulating material (6),
∘ electrically conductive material (31),
∘ thermally insulating material (7),
∘ thermally conductive material (32),
∘ sealing material (34).

9. Method according to one of the preceding patent claims, wherein the thread (1) has different cross-sectional areas (35) in the direction of the extent (2).

10. Tubular thermoelectric module (15), at least comprising a cold side (20), a hot side (21) and also annular components (12) arranged therebetween, wherein the components (12) comprise at least one component (12) selected from the group of
- component (12), comprising thermoelectric material (3),
- component (12), comprising electrically insulating material (6),
- component (12), comprising thermally insulating material (7),
- component (12), comprising electrically conductive material (31),
- component (12), comprising thermally conductive material (32),
- component (12), comprising sealing material (34), **characterized in that** the at least one annular component (12) has been produced by a method according to one of Patent Claims 1 to 9.

## Revendications

1. Procédé de fabrication d'un élément structural (12) pour un module thermoélectrique (15), comprenant au moins les étapes suivantes :
a) fourniture d'au moins un fil (1) ayant une extension (2),
b) fourniture d'un logement de forme tubulaire (13) doté d'une surface circonférentielle extérieure (14),
c) application de matériau thermoélectrique (3) sur l'au moins un fil (1),
d) enroulement de l'au moins un fil (1) autour du logement de forme tubulaire (13), **caractérisé en ce que**
sur la surface circonférentielle extérieure (14), au moins un élément structural (12) de forme annulaire pour un module thermoélectrique (15) est formé, lequel peut être disposé, avec d'autres éléments structuraux (12) de forme annulaire, entre une enveloppe extérieure et une enveloppe intérieure d'un module thermoélectrique de forme tubulaire.

2. Procédé selon la revendication 1, le logement de forme tubulaire (13) possédant au moins un élément jointif (17) circulaire au moins partiellement dans une direction circonférentielle (16), de sorte que dans une direction axiale (18) sur la surface circonférentielle extérieure (14) du logement de forme tubulaire (13) sont formées des poches (19) qui sont au moins partiellement remplies par l'au moins un fil (1) .

3. Procédé selon l'une des revendications 1 ou 2, plusieurs fils (1) étant fournis, lesquels sont appliqués simultanément sur le logement de forme tubulaire (13) dans une étape d).

4. Procédé selon l'une des revendications précédentes, au moins un fil (1) en un matériau non thermoélectrique (4) étant enroulé conjointement.

5. Procédé selon l'une des revendications précédentes, l'étape c) étant au moins partiellement exécutée simultanément avec l'état d) ou après celle-ci.

6. Procédé selon l'une des revendications précédentes, l'au moins un fil (1) possédant, le long de l'extension (2), au moins des matériaux thermoélectriques (3) différents ou des matériaux non thermoélectriques (4).

7. Procédé selon l'une des revendications précédentes, l'au moins un fil (1) étant enduit d'une matière (3, 4) le long de l'extension (2).

8. Procédé selon l'une des revendications précédentes, le fil (1) possédant au moins l'une des propriétés suivantes :
- au moins une fibre (5) qui présente une résistance à la traction d'au moins 200 N/mm² ;
- une pluralité de fibres (5) qui sont torsadées ensemble ;
- des caractéristiques de matière (11) différentes dans au moins une direction radiale (9) ou dans la direction de l'extension (10) ;
- des espaces creux (8), les espaces creux (8) étant au moins partiellement remplis d'au moins une matière du groupe suivant :
∘ matière thermoélectrique (3),
∘ matière électriquement isolante (6),
∘ matière électriquement conductrice (31),
∘ matière thermiquement isolante (7),
∘ matière thermiquement conductrice (32),
∘ matière d'étanchéité (34).

9. Procédé selon l'une des revendications précédentes, le fil (1) possédant des surfaces de section transversale (35) différentes dans le sens de l'extension (2).

10. Module thermoélectrique (15) de forme tubulaire, possédant au moins un côté froid (20), un côté chaud (21) ainsi que des éléments structuraux (12) de forme annulaire disposés entre ceux-ci, les éléments structuraux (12) comprenant au moins un élément structural (12) du groupe
- élément structural (12) comportant une matière thermoélectrique (3),
- élément structural (12) comportant une matière électriquement isolante (6),
- élément structural (12) comportant une matière thermiquement isolante (7),
- élément structural (12) comportant une matière électriquement conductrice (31),
- élément structural (12) comportant une matière thermiquement conductrice (32),
- élément structural (12) comportant une matière d'étanchéité (34),
**caractérisé en ce que**
l'au moins un élément structural (12) de forme annulaire a été fabriqué avec un procédé selon l'une des revendications 1 à 9.
